# EUROPÄISCHE PATENTSCHRIFT

(11) **EP 2 513 356 B1**
(45) Veröffentlichungstag und Bekanntmachung des Hinweises auf die Patenterteilung: **11.12.2013**
(21) Anmeldenummer: 12702440.4
(22) Anmeldetag: 11.01.2012
(51) Int. Cl.: C23C 28/02, F16C 33/12

(54) **GLEITLAGERVERBUNDWERKSTOFF**
SLIDING BEARING COMPOSITE
MATÉRIAU COMPOSITE DE PALIER LISSE

(30) Priorität: 04.03.2011 DE 102011013883
(43) Veröffentlichungstag der Anmeldung: 24.10.2012
(73) Patentinhaber: KS Gleitlager GmbH, 68789 St. Leon-Rot (DE)
(72) Erfinder: PUCHER, Klaus, 86157 Augsburg (DE); KYRSTA, Stepan, 52072 Aachen (DE)
(74) Vertreter: Dreiss
(86) Internationale Anmeldenummer: PCT/EP2012/050323
(87) Internationale Veröffentlichungsnummer: WO 2012/119800

(56) Entgegenhaltungen:
- DE-A1- 10 355 547
- DE-A1- 10 360 818
- DE-A1-102004 038 191
- DE-A1-102005 063 324
- DE-A1-102008 056 965
- DE-A1-102008 060 765
- DE-B3-102006 019 826
- DE-C1- 10 144 126

## Beschreibung

Die Erfindung betrifft einen Gleitlagerverbundwerkstoff mit einer Trägerschicht, insbesondere aus Stahl, mit einer darauf aufgebrachten Lagermetallschicht aus einem Lagermaterial auf Basis einer Kupfer-Zinn- oder Kupfer-Zink-Legierung mit einer Dicke von wenigstens 100 µm, mit einer Zwischenschicht, und mit einer unmittelbar auf der Zwischenschicht durch physikalische Gasphasenabscheidung (PVD) gebildeten zinnhaltigen Laufschicht.

Derartige Gleitlagerverbundwerkstoffe werden als sogenannte Sputterlager, für höchste Anforderungen, typischerweise zur Lagerung der Kurbelwelle oder als Pleuellager bei Kraftfahrzeugmotoren verwendet. Ausgehend von einem abgelängten Platinenabschnitt eines endlos hergestellten und zugeführten streifenförmigen Werkstoffs werden durch Biege-Roll-Prozesse Schalen oder Buchsen gebildet, die dann weiter der PVD Behandlung unterzogen werden.

Bei vorbekannten Gleitlagerverbundwerkstoffen werden regelmäßig Kupferlegierungen als Lagermaterialien der Lagermetallschicht verwendet, auf der eine sehr dünne Zwischenschicht als Diffusionssperre für Zinn ausgebildet ist; diese Zwischenschicht ist bei vorbekannten Gleitlagerverbundwerkstoffen von einer Nickel-, Nickel-Kupfer- oder Nickel-Chrom-Legierung gebildet. Unmittelbar darauf ist die Laufschicht aus Aluminium-Zinn, insbesondere im sogenannten Sputterverfahren, aufgebracht.

Bei vorbekannten Gleitlagerverbundwerkstoffen und hieraus hergestellten Gleitlagern, insbesondere Gleitlagerschalen, besteht das Problem, dass sich Diffusionssperrschichten auf Nickelbasis verhältnismäßig schlecht durch physikalische Gasphasenabscheidung (PVD) abscheiden lassen. Beispielsweise beträgt die hierfür erforderliche Zeit ein Vielfaches von der Zeit, die für die Aufbringung einer Aluminium-Zinn-Legierung (bei gleicher Dicke) erforderlich ist. Deshalb wurde die Dicke der Zwischenschicht seither im Bereich von 1 bis 1,5 µm extremst dünn gehalten, während die Dicke der Laufschicht wenigstens 16 oder gar wenigstens 18 µm betragen hat. Verhältnismäßig dicke Laufschichten auf Aluminium-Zinn-Basis wurden auch deshalb gewählt, weil die Diffusionssperrschichten auf Nickel-Basis eine eher hohe Fressneigung und damit schlechtes Notlaufverhalten aufweisen und daher die Dicke der Laufschicht für den Lebensdauerverschleiß ausgelegt und dimensioniert werden muss.

DE 10 2008 056 965 A1 offenbart einen Gleitlagerverbundwerkstoff mit einer Trägerschicht, einer Lagermetallschicht aus einer CuSn(4-15)- oder einer CuZn(18-43)-Legierung, mit einer Zwischenschicht und einer auf die Zwischenschicht unmittelbar aufgebrachten zinnhaltigen Laufschicht. Sowohl die Zwischenschicht als auch die zinnhaltige Laufschicht sind galvanisch aufgebracht.

DE 10 2005 063 324 A1 offenbart einen Gleitlagerverbundwerkstoff mit einer Trägerschicht, einer Lagermetallschicht aus einer Kupferlegierung mit einer Dicke von 100 µm - 800 µm und mit einer zinnhaltigen Laufschicht, die durch physikalische Gasphasenabscheidung (PFD) aufgebracht sein kann.

DE 10 2006 019 826 B3 offenbart einen Verbundwerkstoff mit einer Trägerschicht und einer mit dem Gleitpartner zusammenwirkenden Gleitschicht aus einer CuNi(1-15)-Sn(2-12)-Legierung einer Dicke von 0,1 - 3 mm.

Der vorliegenden Erfindung liegt die Aufgabe zugrunde, einen Gleitlagerverbundwerkstoff der eingangs beschriebenen Art zu schaffen, dessen Herstellbarkeit unter wirtschaftlichen Gesichtspunkten verbessert ist, wobei die Anpassungsfähigkeit und auch die Fressneigung noch verbessert werden sollen.

Diese Aufgabe wird bei einem Gleitlagerverbundwerkstoff der genannten Art erfindungsgemäß dadurch gelöst, dass das Lagermaterial von einer eher niedriglegierten Kupfer-Zinn- oder Kupfer-Zink-Legierung mit höchstens 6 Gew.-% Zinn oder höchstens 25 Gew.-% Zink gebildet ist, und dass die Zwischenschicht (8) durch physikalische Gasphasenabscheidung (PVD) von CuNi(3-20)Sn(3-10), gegebenenfalls mit weiteren Bestandteilen, gebildet ist und eine Dicke von 1 - 10 µm aufweist.

Es wurde erfindungsgemäß festgestellt, dass der Verbund des nicht ganz so harten Lagermaterials mit der darauf abgeschiedenen Kupfer-Nickel-Zinn-Zwischenschicht nicht nur eine Diffusionssperre für Zinn bildet, sondern zugleich die Fressneigung des Verbundwerkstoffs herabsetzt. In diesem Verbund wirkt also die Zwischenschicht nicht lediglich als Diffusionssperrschicht, sondern sie optimiert die tribologischen Eigenschaften des Gleitlagerverbundwerkstoffs im Zusammenwirken mit der darunter befindlichen Lagermetallschicht und der darüber befindlichen Laufschicht. Es hat sich erfindungsgemäß herausgestellt, dass die Anpassungsfähigkeit und die Einbettfähigkeit für Partikelschmutz verbessert wird. Dies wird darauf zurückgeführt, dass die Zwischenschicht der beanspruchten Zusammensetzung etwas weicher ist als die vorbekannten nickelbasierten Diffusionssperrschichten. Sie kann darüber hinaus auch vorzugsweise dicker ausgebildet werden, da sie sich in PVD-Verfahren gut abscheiden lässt. Sie wirkt aber außerdem oberflächenhärtend in Bezug auf die darunter befindliche verhältnismäßig weiche Lagermetallschicht auf Bronze- oder Messingbasis und damit verschleißmindernd. Bei Partikelschmutz wird zudem die Fressneigung des Verbundwerkstoffs reduziert. Die vorliegende Erfindung geht mithin einen anderen Weg als zurückliegende Versuche, die Lagermetallschicht aus Lagermaterial selbst zu optimieren, was stets zu erhöhten Kosten und/oder höherer Härte in dieser Schicht führte und damit zwar hier und da die Fressneigung verbesserte, sich jedoch typischerweise zu Lasten der Anpassungsfähigkeit des Lagers auswirkte.

Die Lagermetallschicht weist bevorzugtermaßen eine Härte von < 160 HBW 1/10/10, insbesondere < 150 HBW 1/10/10 gemessen nach DIN/ISO 6506-1, auf. Die Härte wird dabei entweder am fertig geformten, also auf Endform gebrachten Gleitlagerverbundwerkstoff mit Trägerschicht und Lagermetallschicht, jedoch noch ohne Zwischenschicht und Laufschicht gemessen, oder sie wird am fertig beschichteten Gleitlagerverbundwerkstoff bestimmt, indem solchenfalls die Laufschicht und die Zwischenschicht in geeigneter Weise entfernt werden, damit die Härte der darunter befindlichen Lagermetallschicht ermittelt werden kann. Die Härte wird also in beiden Fällen senkrecht zur flächenhaften Erstreckung des Werkstoffs oder der Schicht gemessen. Bei einem derartigen Gleitlagerverbundwerkstoff erweist sich der Verbund aus eher weicher Laufschicht und Zwischenschicht als besonders vorteilhaft, weil durch die Zwischenschicht die Verschleißbeständigkeit insgesamt erhöht wird, wobei aber dennoch eine gute Anpassbarkeit und Partikelverträglichkeit erreicht wird.

Nach einer bevorzugten Ausführungsform des erfindungsgemäßen Gleitlagerverbundwerkstoffs ist das Lagermaterial von einer Kupfer-Zink-Legierung mit höchstens 20 Gew.-%, insbesondere höchstens 15 Gew.-% Zink gebildet ist.

Nach einer bevorzugten Ausführungsform des erfindungsgemäßen Gleitlagerverbundwerkstoffs ist das Lagermaterial von einer CuSn(4-5,5)Zn(0,5-1,5)-Legierung, insbesondere von einer CuSn(5)Zn(1)-Legierung gebildet.

Es erweist sich weiter als vorteilhaft, wenn die Dicke der Lagermetallsschicht 100 - 600 µm, insbesondere 150 - 500 µm beträgt.

Im Hinblick auf die Ausbildung der Zwischenschicht erweist es sich weiter als vorteilhaft, wenn sie von einer CuNi(8-18)Sn(5-10) gebildet ist.

Die Dicke der Zwischenschicht beträgt vorzugsweise 1-10 µm, insbesondere 1 - 8 µm, insbesondere 2 - 8 µm, insbesondere 2 - 6 µm und weiter insbesondere 3 - 6 µm.

Die Dicke der Laufschicht beträgt vorteilhafterweise 2 - 20 µm, insbesondere 4 -15 µm und weiter insbesondere 6 - 12 µm.

Die Laufschicht ist vorteilhafterweise von einer AlSn(5-40)-Legierung, gegebenenfalls mit 1 - 4 Gew.-% Silizium, 0,5 - 3 Gew.-% Mangan, 0,5 - 4 Gew.-% Kupfer, gebildet ist und insbesondere von einer AlSn(15-25)-Legierung gebildet. Sie könnte auch aus Reinzinn bestehen.

Weitere Merkmale, Einzelheiten und Vorteile der Erfindung ergeben sich aus den beigefügten Patentansprüchen, wobei für alle Kombinationen der darin genannten Merkmale Schutz in Anspruch genommen wird, und aus der zeichnerischen Darstellung und nachfolgenden Beschreibung einer bevorzugten Ausführungsform des erfindungsgemäßen Gleitlagerverbundwerkstoffs.

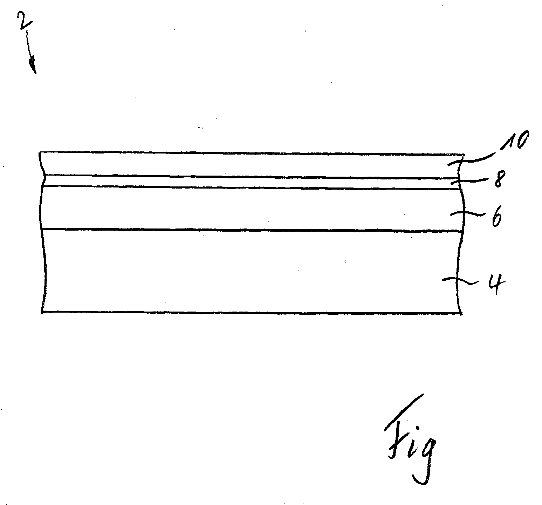

In der Zeichnung zeigt:

Die Figur eine schematische Schnittansicht durch einen erfindungsgemäßen Gleitlagerverbundwerkstoff.

Die Figur zeigt im Schnitt einen insgesamt mit dem Bezugszeichen 2 bezeichneten Gleitlagerverbundwerkstoff mit einer Trägerschicht 4, insbesondere aus Stahl, und einer darauf aufgebrachten Lagermetallschicht aus einem Lagermaterial auf Basis einer Kupfer-Zinn- oder Kupfer-Zink-Legierung mit einer Dicke von wenigstens 100 µm, typischerweise von 150 bis 600 µm. Auf der Lagermetallschicht 6 ist eine Zwischenschicht 8 im Wege der physikalischen Gasphasenabscheidung (PVD), typischerweise durch Sputtern, ausgebildet. Diese Zwischenschicht 8 ist gemäß dem Ausführungsbeispiel vorzugsweise von einer CuNi(3-20)Sn(3-10)-Legierung gebildet und weist eine Dicke von 1 - 8 µm, insbesondere 2 - 8 µm, insbesondere 2 - 6 µm und weiter insbesondere 3 - 6 µm auf. Auf dieser Zwischenschicht 8 ist dann eine gegenüber dieser Schicht dickere zinnhaltige Laufschicht 10, insbesondere aus Reinzinn oder Aluminium-Zinn, wiederum durch PVD-Verfahren, vorzugsweise Sputtern, abgeschieden.

Bevorzugte Zusammensetzungen des erfindungsgemäßen Gleitlagerverbundwerkstoffs zeigen die folgenden Ausführungsbeispiele:

1. Trägerschicht: beispielhaft Stahl

Lagermetallschicht: CuSn5Zn1

Zwischenschicht:CuNi15Sn8 mit Dicke beispielhaft ca.2,5µm

Laufschicht: AlSn20Cu1 mit Dicke beispielhaft ca.15µm

2. Trägerschicht: beispielhaft Stahl

Lagermetallschicht: CuSn5Zn1

Zwischenschicht:CuNi15Sn8 mit Dicke beispielhaft ca.5µm

Laufschicht: Reinzinn mit Dicke beispielhaft ca.5µm

3. Trägerschicht: beispielhaft Stahl

Lagermetallschicht: CuSn5Zn1

Zwischenschicht:CuNi5,5Sn7Zn2 mit Dicke beispielhaft ca.3µm

Laufschicht: AlSn25Cu2,5 mit Dicke beispielhaft ca.14µm

Der bevorzugte und beispielhaft beschriebene Gleitlagerverbundwerkstoff eignet sich für den Einsatz als Gleitlagerschale und -buchse, insbesondere für Hauptlager- und Pleuellageranwendungen. Er weist eine hervorragende Anpassbarkeit und auch bei sehr weitgehender Abnutzung ein sehr gutes Notlaufverhalten bei geringer Fressneigung auf, obschon eine verhältnismäßig weiche und kostengünstige Lagermetallschicht verwendet wird.

## Patentansprüche

1. Gleitlagerverbundwerkstoff (2) mit einer Trägerschicht (4), insbesondere aus Stahl, mit einer darauf aufgebrachten Lagermetallschicht (6) aus einem Lagermaterial auf Basis einer Kupfer-Zinn- oder Kupfer-Zink-Legierung mit einer Dicke von wenigstens 100 µm, mit einer Zwischenschicht (8), und mit einer unmittelbar auf der Zwischenschicht (8) durch physikalische Gasphasenabscheidung (PVD) gebildeten zinnhaltigen Laufschicht (10), **dadurch gekennzeichnet, dass** das Lagermaterial von einer Kupfer-Zinn- oder Kupfer-Zink-Legierung mit höchstens 6 Gew.-% Zinn oder höchstens 25 Gew.-% Zink gebildet ist, und dass die Zwischenschicht (8) durch physikalische Gasphasenabscheidung (PVD) von CuNi(3-20)Sn(3-10), gegebenenfalls mit weiteren Bestandteilen, gebildet ist und eine Dicke von 1 - 10 µm aufweist.

2. Gleitlagerverbundwerkstoff nach Anspruch 1, **dadurch gekennzeichnet, dass** die Lagermetallschicht (6) eine Härte von < 160 HBW 1/10/10, insbesondere < 150 HBW 1/10/10 gemessen nach DIN/ISO 6506-1, aufweist.

3. Gleitlagerverbundwerkstoff nach Anspruch 1 oder 2, **dadurch gekennzeichnet, dass** das Lagermaterial von einer Kupfer-Zink-Legierung mit höchstens 20 Gew.-%, insbesondere höchstens 15 Gew.-% Zink gebildet ist.

4. Gleitlagerverbundwerkstoff nach Anspruch 1 oder 2, **dadurch gekennzeichnet, dass** das Lagermaterial von einer CuSn(4-5,5)Zn(0,5-1,5)-Legierung, insbesondere von einer CuSn(5)Zn(1)-Legierung gebildet ist.

5. Gleitlagerverbundwerkstoff nach einem der vorstehenden Ansprüche, **dadurch gekennzeichnet, dass** die Dicke der Lagermetallschicht (6) 100 - 600 µm, insbesondere 150 -500 µm beträgt.

6. Gleitlagerverbundwerkstoff nach einem der vorstehenden Ansprüche, **dadurch gekennzeichnet, dass** die Zwischenschicht (8) von einer CuNi(8-18)Sn(5-10)-Legierung, gegebenenfalls mit weiteren Bestandteilen, gebildet ist.

7. Gleitlagerverbundwerkstoff nach einem der vorstehenden Ansprüche, **dadurch gekennzeichnet, dass** die Dicke der Zwischenschicht (8) 1 - 8 µm, insbesondere 2 - 8 µm, insbesondere 2 - 6 µm und weiter insbesondere 3 - 6 µm beträgt.

8. Gleitlagerverbundwerkstoff nach einem der vorstehenden Ansprüche, **dadurch gekennzeichnet, dass** die Dicke der Laufschicht (10) 2 - 20 µm, insbesondere 4 - 15 µm und weiter insbesondere 6 - 12 µm beträgt.

9. Gleitlagerverbundwerkstoff nach einem der vorstehenden Ansprüche, **dadurch gekennzeichnet, dass** die Laufschicht (10) von einer AlSn(5-40)-Legierung, gegebenenfalls mit 1 -4 Gew.-% Silizium, 0,5 -3 Gew.-% Mangan, 0,5 - 4 Gew.-% Kupfer, gebildet ist und insbesondere von einer AlSn(15-25)-Legierung gebildet ist.

## Claims

1. A plain bearing composite material (2) with a carrying layer (4), particularly of steel, with a bearing metal coating (6) of a bearing material based on a copper-tin or copper-zinc ally with a thickness of at least 100 µm, with an intermediate layer (8) and with a running surface (10) containing tin formed directly on the intermediate layer (8) by physical vapour deposition (PVD), **characterised in that** the bearing material is formed from a copper-tin or copper-zinc alloy with a maximum of 6% by weight of tin or a maximum of 25% by weight of zinc, and **in that** the intermediate layer (8) is formed by physical vapour deposition (PVD) of CuNi(3-20)Sn(3-10), if necessary with further components, and has a thickness of 1 - 10 µm.

2. The plain bearing composite material according to Claim 1, **characterised in that** the bearing metal coating (6) has a hardness of < 160 HBW 1/10/10, in particular < 150 HBW 1/10/10, measured according to DIN/ISO 6506-1.

3. The plain bearing composite material according to Claim 1 or 2, **characterised in that** the bearing material is formed from a copper-zinc alloy with a maximum of 20% by weight, in particular a maximum of 15% by weight, of zinc.

4. The plain bearing composite material according to Claim 1 or 2, **characterised in that** the bearing material is formed from a CuSn(4-5.5)Zn(0.5-1.5) alloy, in particular from a CuSn(5)Zn(1) alloy.

5. The plain bearing composite material according to any one of the preceding claims, **characterised in that** the thickness of the bearing metal coating (6) is 100 - 600 µm, in particular 150 - 500 µm.

6. The plain bearing composite material according to any one of the preceding claims, **characterised in that** the intermediate layer (8) is formed from a CuNi(8-18)Sn(5-10) alloy, if necessary with further components.

7. The plain bearing composite material according to any one of the preceding claims, **characterised in that** the thickness of the intermediate layer (8) is 1 -8 µm, in particular 2 - 8 µm, in particular 2 -6 µm, and further in particular 3 - 6 µm.

8. The plain bearing composite material according to any one of the preceding claims, **characterised in that** the thickness of the running surface (10) is 2 - 20 µm, in particular 4 - 15 µm and further in particular 6 - 12 µm.

9. The plain bearing composite material according to any one of the preceding claims, **characterised in that** the running surface (10) is formed from an AlSn(5-40) alloy, if necessary with 1-4% by weight of silicon, 0.5-3% by weight of manganese, 0.5-4% by weight of copper, and in particular is formed from an AlSn(15-25) alloy.

## Revendications

1. Matériau composite (2) pour palier lisse, avec une couche de support (4), en particulier en acier, sur laquelle est appliquée une couche de métal antifriction (6) constituée d'un matériau antifriction à base d'un alliage cuivre-étain ou cuivre-zinc ayant une épaisseur d'au moins 100 µm, avec une couche intermédiaire (8), et avec une couche de roulement (10) contenant de l'étain, formée par dépôt physique en phase gazeuse (PVD) directement sur la couche intermédiaire (8), **caractérisé en ce que** le matériau antifriction est formé d'un alliage cuivre-étain ou cuivre-zinc contenant au plus 6 % en poids d'étain ou au plus 25 % en poids de zinc, et la couche intermédiaire (8) est formée de CuNi(3-20)Sn(3-10) par dépôt physique en phase gazeuse, éventuellement avec d'autres composants, et présente une épaisseur de 1 à 10 µm.

2. Matériau composite pour palier lisse selon la revendication 1, **caractérisé en ce que** la couche de métal antifriction (6) présente une dureté < 160 HBW 1/10/10, en particulier < 150 HBW 1/10/10 mesurée selon la norme DIN/ISO 6506-1.

3. Matériau composite pour palier lisse selon la revendication 1 ou 2, **caractérisé en ce que** le matériau antifriction est formé d'un alliage cuivre-zinc avec au plus 20 % en poids, en particulier au plus 15 % en poids de zinc.

4. Matériau composite pour palier lisse selon la revendication 1 ou 2, **caractérisé en ce que** le matériau antifriction est formé d'un alliage CuSn(4-5,5)Zn(0,5-1,5), en particulier d'un alliage CuSn(5)Zn(1).

5. Matériau composite pour palier lisse selon l'une quelconque des revendications précédentes, **caractérisé en ce que** l'épaisseur de la couche de métal antifriction (6) est de 100 à 600 µm, en particulier 150 à 500 µm.

6. Matériau composite pour palier lisse selon l'une quelconque des revendications précédentes, **caractérisé en ce que** la couche intermédiaire (8) est formée d'un alliage CuNi(8-18)Sn(5-10), éventuellement avec d'autres composants.

7. Matériau composite pour palier lisse selon l'une quelconque des revendications précédentes, **caractérisé en ce que** l'épaisseur de la couche intermédiaire (8) est de 1 à 8 µm, en particulier 2 à 8 µm, de manière plus particulière 2 à 6 µm et de manière encore plus particulière 3 à 6 µm.

8. Matériau composite pour palier lisse selon l'une quelconque des revendications précédentes, **caractérisé en ce que** l'épaisseur de la couche de roulement (10) est de 2 à 20 µm, en particulier 4 à 15 µm et de manière plus particulière 6 à 12 µm.

9. Matériau composite pour palier lisse selon l'une quelconque des revendications précédentes, **caractérisé en ce que** la couche de roulement (10) est formée d'un alliage AlSn(5-40), éventuellement avec 1 à 4 % en poids de silicium, 0,5 à 3 % en poids de manganèse, 0,5 à 4 % en poids de cuivre et est en particulier formée d'un alliage AlSn(15-25).
